# EUROPEAN PATENT APPLICATION

(11) **EP 4 738 363 A1**
(43) Date of publication of application: **06.05.2026**
(21) Application number: 24899103.6
(22) Date of filing: 03.04.2024
(51) Int. Cl.: G11C 11/42

(54) **OPTICAL STORAGE MEDIUM, SUPER-RESOLUTION INFORMATION READING METHOD AND DEVICE BASED ON MEDIUM, AND SUPER-RESOLUTION INFORMATION WRITING METHOD AND DEVICE BASED ON MEDIUM**

(30) Priority: 07.12.2023 CN 202311672209
(71) Applicant: Shanghai Institute of Optics and Finemechanics, Chinese Acamedy of Sciences, Shanghai 201800 (CN)
(72) Inventor: ZHAO, Miao, Shanghai 201800 (CN); RUAN, Hao, Shanghai 201800 (CN); WEN, Jing, Shanghai 201800 (CN); HU, Qiao, Shanghai 201800 (CN)
(74) Representative: karo IP
(86) International application number: PCT/CN2024/085711
(87) International publication number: WO 2025/118450

(57) **Abstract**

Optical Storage Medium and Super-Resolution Information Read-Write Method and Apparatus Based on the Same. The optical storage medium comprises the following components in molar percentages: a photoinitiator from 0.1% to 5%; an aggregation-induced emission dye from 0.1% to 5%; a metal ion compound from 0.1% to 5%; and a monomer from 85% to 99.7%. The information writing method includes: irradiating the optical storage medium with a solid beam of wavelength λ₁ to enhance the fluorescence intensity in the irradiated region; irradiating the surrounding area of the solid-beam-irradiated region with a hollow beam of wavelength λ₂ to suppress the fluorescence intensity in that surrounding area; and recording information by utilizing the fluorescence contrast between the irradiated region and the surrounding area, thereby forming information recording points with dimensions smaller than the diffraction limit. The present invention employs super-resolution writing and super-resolution reading based on stimulated emission depletion microscopy. It addresses issues inherent in conventional read-write methods, such as the inability to break the diffraction limit, low material transmittance, and limitations on the number of three-dimensional recording layers. This significantly enhances optical storage density and capacity.

## Description

### TECHNICAL FIELD

The present invention relates to the technical field of optical storage, and in particular, to an optical storage medium, a super-resolution information read-write method, and an apparatus based on the same.

### BACKGROUND ART

With the emergence of the Fourth Industrial Revolution centered on intelligent manufacturing and the rapid development of the internet, the Internet of Things, cloud computing, and artificial intelligence, data volume has experienced explosive growth. Currently, information storage methods dominated by magnetic storage technology generally suffer from disadvantages such as short lifespan and high energy consumption. In particular, with the surge in total data volume, the resulting storage media and power consumption losses will inevitably significantly increase the cost of data storage. In contrast, optical storage possesses the characteristic of long-term "offline" capability, with a lifecycle of up to 50 years. During this period, its power consumption is less than 1% of that of hard disk systems, enabling secure, long-term, energy-efficient data preservation while offering features such as resistance to electromagnetic interference and immutability. However, traditional optical storage systems are constrained by the optical diffraction limit, with recorded spot sizes approximately half the wavelength. During the information writing process, when the distance between adjacent recording spots is smaller than the scale of optical diffraction, the writing of the second spot interferes with that of the first, causing the writing areas of the two adjacent spots to overlap. Moreover, the contrast between written and unwritten regions is very low, making the two spots indistinguishable (Applied Physics Letters, 2008, 92(9): 90-93 and Optics Express, 2013, 21(9): 10831-10840). During the information reading process, constrained by the optical diffraction limit, super-resolution recording spots cannot be distinguished, thereby preventing the realization of super-resolution reading. Therefore, the limitation imposed by the optical diffraction limit presents significant challenges for optical storage, both in writing and reading information at super-resolution scales, hindering further increases in total storage capacity and limiting its application in the era of big data. Furthermore, super-resolution optical storage technologies based on green fluorescent protein and diarylethene dyes employ the simultaneous action of three laser beams to achieve super-resolution information writing, including two writing beams and one quenching beam. This approach achieves super-resolution recording through a quenching mechanism. However, both the writing and reading processes require pre-treatment of the medium material to maintain the stability of the recorded information's quenched state. Additionally, the storage system necessitates maintaining high three-dimensional coincidence for all three beams simultaneously, resulting in excessive system complexity. Moreover, the super-resolution effect based on the quenching principle is not particularly outstanding. Notably, using green fluorescent protein as the storage medium also has the drawback of a short storage lifespan (refer to CN108877844B and Nature, 2011, 478(7368): 204-208).

In optical storage systems, in addition to breaking the diffraction limit to shrink the recording spot size to the super-resolution scale, the architecture can be extended from traditional and commonly used single-layer optical storage to a three-dimensional multi-layer storage framework. This approach enables full utilization of the originally unused 99.99% of the storage medium volume. Existing traditional optical storage systems based on reflective readout support up to six recording layers, offering limited improvement in storage capacity (see Wikipedia Contributors. Blu-ray[EB/OL]. (2019-02). https://en.wikipedia.org/wiki/Blu-ray).On the other hand, fluorescence-based three-dimensional optical storage leverages the high specificity and accuracy of fluorescent signal readout to effectively enhance the volume utilization of the storage medium. However, it is constrained by the transmittance of the medium material and the issue of inter-layer crosstalk during multi-layer writing (see Light: Science & Applications, 2014, 3(e177): 1-11), which prevents achieving a higher number of storage layers and thus limits the overall storage capacity improvement. Furthermore, fluorescence-based three-dimensional optical storage using polymers combined with fluorescent dyes (e.g., The Journal of Chemical Physics, 1957, 27(3): 758-763; Small, 2008, 4(1): 134-142; and Journal of Physical Chemistry A, 2009, 113(49): 13633-13644) predominantly employs conventional fluorescent dyes, which suffer from aggregation-caused quenching issues. For example, dyes such as pyrene, rhodamine, and coumarin emit strong fluorescence in a dissolved state, but their fluorescence quenches as aggregation increases. This leads to the loss of fluorescent readout signals from the recording spots, thereby hindering the development of polymer-based fluorescence three-dimensional multi-layer optical storage.

Based on the aforementioned optical storage technologies, it is evident that existing methods are limited by the optical diffraction limit, which prevents further reduction in recording spot size and results in low overall storage capacity. Fluorescence-based three-dimensional optical storage, which relies on fluorescent signal readout, is constrained by the transmittance of the medium material, inter-layer crosstalk during multi-layer writing, and the tendency of conventional fluorescent dyes to suffer from aggregation-caused quenching. These limitations restrict the increase in the number of recording layers and hinder significant improvements in overall storage capacity. In existing technologies, particularly in optical storage media based on polymer materials, some methods require heating the material first and then using a single-wavelength laser to form information recording spots. This process is complex, and the size of the recording spots remains limited by the diffraction limit (see CN1662967A). Additionally, during the writing process of information recording spots, only a single-wavelength solid laser beam is used to induce aggregation-induced emission in the storage medium. There is no capability to employ a second-wavelength hollow laser beam to suppress aggregation-induced emission in the surrounding area of the first solid beam irradiation, thus preventing the formation of information recording spots smaller than the diffraction limit (see CN110527523A).During the information readout process, conventional methods rely solely on confocal imaging technology with single-wavelength excitation for readout. They do not implement the principle of stimulated emission depletion microscopy, which uses a second annular hollow suppression laser beam to stimulate excited-state electrons for super-resolution readout. As a result, recording spots smaller than the diffraction limit cannot be resolved. Moreover, methods that use high-power single-wavelength laser quenching to create dark spots as recording points in the central region of information spots can only achieve super-resolution recording for individual spots. These methods fail to address the mutual interference between two or more adjacent recording spots, cannot reduce the spacing between multiple spots, and thus do not effectively improve overall storage capacity (see CN114621395A). Furthermore, with such methods, the inter-layer spacing is greater than 2 µm and cannot be further reduced.

### SUMMARY OF THE INVENTION

To address the aforementioned deficiencies in the prior art, the objective of the present invention is to provide an optical storage medium, a super-resolution information read-write method, and an apparatus based on the same. These innovations enable simultaneous super-resolution writing using dual-wavelength lasers and super-resolution readout based on the principle of stimulated emission depletion microscopy. They overcome the limitations of conventional read-write methods, such as the inability to break the diffraction limit, restrictions on the number of three-dimensional recording layers, and low transmittance of fluorescence-based three-dimensional storage medium materials. By increasing the number of recording layers, this invention enhances storage capacity and density, demonstrating significant application value in the field of fluorescence-based three-dimensional super-resolution optical storage.

To achieve the above objective, the technical solution of the present invention is as follows: The present invention provides an optical storage medium comprising a photoinitiator, a monomer, a metal ion compound, and an aggregation-induced emission dye. The molar percentages of each component relative to the total material are as follows: the photoinitiator ranges from 0.1% to 5%, the aggregation-induced emission dye ranges from 0.1% to 5%, the metal ion compound ranges from 0.1% to 5%, and the monomer ranges from 85% to 99.7%. Furthermore, the optical storage medium combines the metal ion compound with the aggregation-induced emission dye to enhance the fluorescence contrast of the information recording points.

The present invention also provides a super-resolution information writing method based on the aforementioned optical storage medium, comprising:
Irradiating the optical storage medium with a solid beam of wavelength λ₁ to induce an aggregation-induced emission effect in the irradiated region, thereby enhancing the fluorescence intensity;
Irradiating the surrounding region of said solid-beam-irradiated area with a hollow beam of wavelength λ₂ to induce a suppression effect on aggregation-induced emission, thereby inhibiting the fluorescence intensity.

Recording information by utilizing the fluorescence contrast between said irradiated region and the surrounding area, thereby forming information recording points with dimensions smaller than the diffraction limit.

Preferably, the central positions of the solid beam and the hollow beam coincide in three-dimensional space.

Preferably, the fluorescence contrast between the information recording points and the unrecorded information regions is greater than 10:1.

Preferably, the size of the information recording points is smaller than the diffraction limit λ₁/2NA, where NA represents the numerical aperture of the objective lens.

Preferably, the metal ion compound comprises one or more compounds soluble in organic solvents containing Li⁺ ions, Zn²⁺ ions, Yb³⁺ ions, Zr⁴⁺ ions, or Mg²⁺ ions.

Preferably, the optical storage medium exhibits a single-photon absorption range from 200 nm to 400 nm and a two-photon absorption range from 400 nm to 800 nm.

Preferably, the aggregation-induced emission dye comprises at least one of tetraphenylethylene-based compounds, hexaphenylsiloxane-based compounds, or distyrylanthracene-based compounds.

Preferably, the monomer comprises at least one selected from the group consisting of 1,6-hexanediol diacrylate, pentaerythritol tetraacrylate, trimethylolpropane triacrylate, ditrimethylolpropane tetraacrylate, tris(2-hydroxyethyl)isocyanurate triacrylate, and dipentaerythritol pentaacrylate.

Preferably, the photoinitiator comprises at least one selected from the group consisting of IRGACURE-250, IRGACURE-907, IRGACURE-184, IRGACURE-369, IRGACURE-819, IRGACURE-1173, IRGACURE-784, IRGACURE-ITX, and IRGACURE-DETC, or a mixture thereof.

Preferably, the optical storage medium is attached to a substrate and subjected to UV pre-curing. The present invention also provides an information super-resolution readout method based on an optical storage medium, characterized in that the method comprises the following steps: Irradiating the optical storage medium with a solid beam of wavelength λ₃ and a hollow beam of wavelength λ₄, wherein said optical storage medium is doped with an aggregation-induced emission dye. The solid beam of wavelength λ₃ promotes spontaneous radiation by exciting ground-state electrons to the excited state, while the hollow beam of wavelength λ₄ induces stimulated emission from the excited-state electrons. The fluorescence-enhanced signals generated by aggregation-induced emission are then collected to read the information recording points, wherein wavelength λ₄ is greater than wavelength λ₃.

On the other hand, the present invention provides an information writing device based on an optical storage medium, comprising an optical path module and a control module;
Among them, the optical path module is configured to form a solid beam of wavelength λ₁ and a hollow beam of wavelength λ₂. The solid beam of wavelength λ₁ irradiates the optical storage medium to induce an aggregation-induced emission effect in the irradiated region, thereby enhancing the fluorescence intensity, wherein the optical storage medium is doped with an aggregation-induced emission dye. The hollow beam of wavelength λ₂ irradiates the surrounding region of the solid-beam-irradiated area to suppress the aggregation-induced emission effect, thereby inhibiting the fluorescence intensity. Information is recorded by utilizing the fluorescence contrast between the irradiated region and the surrounding area, forming information recording points with dimensions smaller than the diffraction limit;

The control module is configured to control the displacement of the objective lens or the optical storage medium in the z-direction to adjust the focusing positions of the solid beam and the hollow beam within the optical storage medium.

Furthermore, the optical path module comprises a first writing laser module, a first lens, a first pinhole, a second lens, a first dichroic mirror, a second writing laser module, a third lens, a second pinhole, a fourth lens, a vortex phase plate, a second dichroic mirror, and an objective lens;
Herein, the first writing laser module emits a continuous wave or pulsed laser beam with a wavelength ranging from 200 nm to 400 nm or from 400 nm to 800 nm, respectively. This beam passes sequentially through the first lens, the first pinhole, the second lens, and the first dichroic mirror before being focused by the objective lens into a solid beam of wavelength λ₁ onto the optical storage medium;
The second writing laser module emits a continuous or pulsed laser beam with a wavelength range of 500 nm to 800 nm, which passes through a third lens, a second pinhole, a fourth lens, and a vortex phase plate to form a hollow beam of wavelength λ₂. This beam then travels through a second dichroic mirror and a first dichroic mirror before entering the objective lens. Together with the solid beam of wavelength λ₁, it is focused onto the same position within the optical storage medium. The focal planes of the solid beam and the hollow beam are spatially coincident, and their central positions align in three-dimensional space;
The present invention further provides an information super-resolution readout device based on an optical storage medium, comprising a readout optical path module configured to generate dual beams, namely a solid beam of wavelength λ₃ and a hollow beam of wavelength λ₄*.* The dual beams are used to irradiate the optical storage medium, wherein the solid beam of wavelength λ₃ induces spontaneous radiation by exciting ground-state electrons to the excited state, and the hollow beam of wavelength λ₄ induces stimulated emission from the excited-state electrons. Fluorescence-enhanced signals generated by aggregation-induced emission are collected to read information recording points, where wavelength λ₄ is greater than wavelength λ₃.

Compared with the prior art, the beneficial effects of the present invention are as follows:
1, The present invention provides a super-resolution information writing method and apparatus based on an optical storage medium incorporating aggregation-induced emission dyes. This enables simultaneous super-resolution writing using dual laser beams, achieving an emission fluorescence intensity contrast greater than 10:1 between recorded and unrecorded regions. Within the wavelength range of the system's readout light, the transmittance of the storage medium exceeds 80%, allowing for three-dimensional fluorescence storage recording of more than 10 layers or even up to 100 layers, with an inter-layer spacing less than or equal to 1.5 µm. This effectively addresses the limitations in existing optical storage where single-spot size and track pitch are constrained by the optical diffraction limit, as well as the issue of low volumetric utilization efficiency of the storage medium;
2, The present invention provides an optical storage medium that enhances the fluorescence contrast of information recording points by combining a metal ion compound with an aggregation-induced emission dye;
3, The present invention provides an optical storage medium that can be rapidly formed into disks on substrates using a spin-coating process, enabling large-scale and fast production.
4, The present invention provides a super-resolution information read-write method and apparatus based on an optical storage medium incorporating aggregation-induced emission dyes. It simultaneously employs dual laser beams for super-resolution writing and applies the principle of stimulated emission depletion microscopy for super-resolution readout. The super-resolution writing and readout principles adopted in this invention are entirely different from those based on green fluorescent protein or diarylethene thin-film media, which require the additional introduction of permanent quenching light and rely on multiple laser beams to repeatedly modulate the bright and dark states of the storage medium, achieving super-resolution storage recording using dark spots (see CN108877844B and Nature, 2011, 478(7368): 204-208). In contrast, the present invention modulates the enhanced fluorescence intensity resulting from the aggregation-induced emission effect in the irradiated region using two writing beams.

### BRIEF DESCRIPTION OF THE DRAWINGS

Figure 1 is a schematic diagram illustrating super-resolution optical storage recording using the optical storage medium of the present invention.
Figure 2 is a schematic diagram of the optical path of the dual-beam laser super-resolution information writing device at the super-resolution scale according to the present invention.
Figure 3 is a schematic diagram of the optical path of the dual-beam super-resolution information readout device based on the optical storage medium of the present invention.
Figure 4 shows the readout results of 35-layer three-dimensional optical storage recording with an inter-layer spacing of 1.5 µm in Example 1 of the present invention.
Figure 5 illustrates the reduction in information recording point size under different power levels of the suppression beam in Example 3 of the present invention.
Figure 6 is a comparative result diagram between single-beam non-super-resolution readout and dual-beam stimulated emission depletion microscopy (STED) super-resolution readout in Example 3 of the present invention.
Figure 7 shows the cross-sectional results of 100-layer three-dimensional optical storage recording with an inter-layer spacing of 1 µm in Example 3 of the present invention.
Figure 8 presents the transmittance results of the optical storage medium material in Example 3 of the present invention.

### DETAILED DESCRIPTION OF THE INVENTION

The technical solutions in the embodiments of the present invention will be described clearly and completely below in conjunction with the embodiments of the present invention. It is evident that the described embodiments are only a part of the embodiments of the present invention, rather than all of them. All other embodiments obtained by those of ordinary skill in the art based on the embodiments of the present invention without creative efforts shall fall within the scope of protection of the present invention.

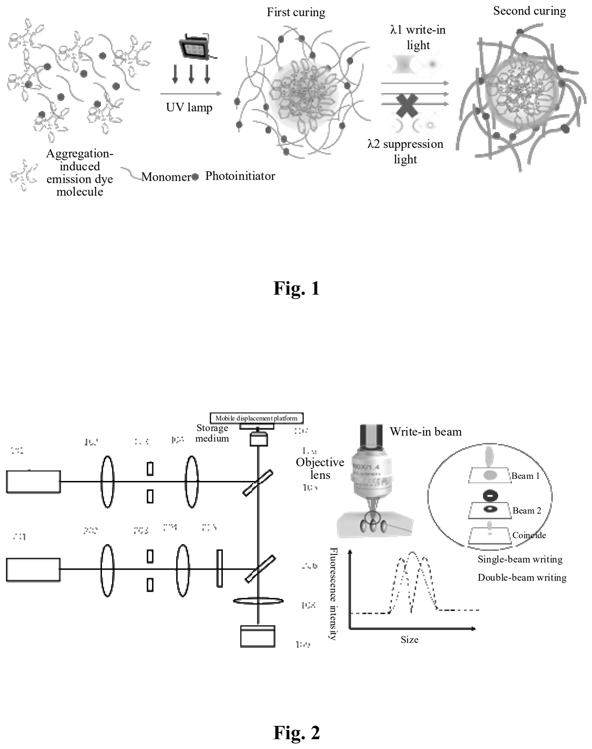

Please refer to Fig. 1, which is a schematic diagram illustrating the recording process of super-resolution optical storage using the optical storage medium of the present invention. The present invention is based on an optical storage medium that enables super-resolution writing and reading of information. This optical storage medium achieves initial curing under ultraviolet lamp irradiation, followed by a second curing under the irradiation of a writing beam. Specifically, the writing beam is a solid beam with a wavelength of λ₁, which further enhances the polymerization degree of the optical storage medium, restricts the rotational motion of the aggregation-induced emission dye molecules in the material, improves the aggregation-induced emission efficiency, and increases the coplanarity of the side phenyl rings with the central silicon ring of the dye molecules. This enhances the conjugation degree of the dye molecules, shifts the emission spectrum to longer wavelengths, and improves the fluorescence contrast between the written and unwritten regions. The inhibition beam is a hollow beam with a wavelength of λ₂, which irradiates the surrounding area of the region exposed to the solid beam of wavelength λ₁, thereby suppressing the aggregation-induced emission phenomenon in the peripheral region. As a result, the center of the writing beam-irradiated area in the optical storage medium exhibits enhanced fluorescence intensity, while the periphery shows suppressed fluorescence intensity. Information is recorded by utilizing the fluorescence contrast between the center and the periphery (preferably, the fluorescence contrast is greater than 10:1), forming information recording points. Simultaneously, the size of a single information recording point can be smaller than the diffraction limit (λ₁/2NA), where NA is the numerical aperture of the objective lens in the optical storage system. Preferably, the central positions of the inhibition beam and the writing beam coincide in three-dimensional space, which is a prerequisite for achieving super-resolution-sized information recording points and track spacing.
(1) Place a photoinitiator (0.1% to 5% by molar ratio), an aggregation-induced emission dye (0.1% to 5%), a metal ion compound (0.1% to 5%), and a monomer (85% to 99.7%) in an acetone solution. After mixing via ultrasonication, remove all acetone by baking in an oven to obtain the optical storage medium material.
(2) Mix the optical storage medium material from step (1) with the organic solvent tetrafluoropropanol or acetone in a certain proportion, then drop the mixture onto a substrate rotating at a low speed (200 rpm to 600 rpm). Subsequently, increase the rotational speed of the substrate to 800 rpm to 2000 rpm to allow the solution to flow outward radially on the substrate until evenly distributed. Finally, raise the substrate's rotational speed to 4800 rpm to 6500 rpm to completely evaporate and remove the mixed organic solvent.
(3) Use a UV curing lamp to expose the uniformly distributed optical storage medium material on the substrate and achieve the first pre-curing, thereby obtaining a solid storage medium film, i.e., the UV-pre-cured optical storage medium.

Please refer to Fig. 2, which is a schematic diagram of the optical path for the dual-beam laser super-resolution information writing device at the super-resolution scale according to the present invention. The optical path module of this dual-beam laser super-resolution writing device comprises a first writing laser module 101, a first lens 102, a first pinhole 103, a second lens 104, a first dichroic mirror 105, a second writing laser module 201, a third lens 202, a second pinhole 203, a fourth lens 204, a vortex phase plate 205, a second dichroic mirror 206, and an objective lens 106.The first writing laser module 101 emits a continuous wave or pulsed laser beam with a wavelength ranging from 200 nm to 400 nm or from 400 nm to 800 nm, respectively. This beam passes sequentially through the first lens 102, the first pinhole 103, the second lens 104, and the first dichroic mirror 105, and is then focused by the objective lens 106 into a solid beam of wavelength λ₁ onto the optical storage medium. The second writing laser module 201 emits a continuous or pulsed laser beam with a wavelength range of 500 nm to 800 nm. This beam passes through the third lens 202, the second pinhole 203, the fourth lens 204, and the vortex phase plate 205 to form a hollow beam of wavelength λ₂. Subsequently, it travels through the second dichroic mirror 206 and the first dichroic mirror 105 before entering the objective lens 106, where it is focused together with the solid beam of wavelength λ₁ onto the same position within the optical storage medium. The central positions of the hollow beam of wavelength λ₂ and the solid beam of wavelength λ₁ coincide in three-dimensional space. This dual-beam laser super-resolution writing system further includes a control module, which is configured to control the displacement of the objective lens or the optical storage medium in the z-direction to adjust the focusing position of the laser beams within the optical storage medium. Specifically, the control module may be implemented as a displacement stage 107 that carries the optical storage medium. Optionally, a fifth lens 108 and a camera 109 may be sequentially placed in the direction opposite to the objective lens 106 relative to the first dichroic mirror 105 to form a confocal imaging system for real-time observation of the information writing process. Thus, the dual-beam laser super-resolution writing device features a simple optical path design, effectively reducing system complexity.

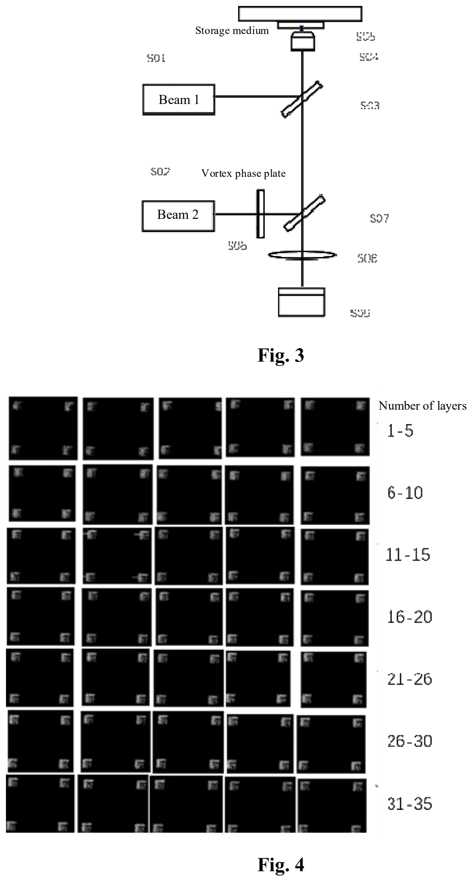

Please refer to Fig. 3, which is a schematic diagram of the optical path for the dual-beam super-resolution information readout device based on the optical storage medium according to the present invention. The optical path of this dual-beam laser readout device is as follows: a first laser beam S01 (wavelength λ₃) passes through a dichroic mirror S03 and enters an objective lens S04, where it is focused onto the optical storage medium S05. A second laser beam S02 (wavelength λ₄) passes through a vortex phase plate S06 to form an annular hollow suppression beam (annular hollow spot), which then travels through a dichroic mirror S07 and enters the objective lens S04 to be focused onto the optical storage medium S05. The signal is collected by a lens S08 and directed to a weak-light detector S09 for super-resolution readout of the information recording points, wherein wavelength λ₄ is greater than wavelength λ₃. Both the S01 and S02 dual beams are focused onto the storage medium S05, i.e., irradiated onto the optical storage medium. The solid beam of wavelength λ₃ induces spontaneous radiation by exciting ground-state electrons to the excited state, while the hollow beam of wavelength λ₄ induces stimulated emission from the excited-state electrons. The fluorescence-enhanced signals generated by aggregation-induced emission are then collected to read the information recording points.

The present invention utilizes an optical storage medium comprising a photoinitiator, a monomer, a metal ion compound, and an aggregation-induced emission dye. In specific embodiments, the molar percentages of each component relative to the total material are as follows: the photoinitiator ranges from 0.1% to 5%, the aggregation-induced emission dye ranges from 0.1% to 5%, the metal ion compound ranges from 0.1% to 5%, and the monomer ranges from 85% to 99.7%. As an example, the aggregation-induced emission dye comprises at least one selected from tetraphenylethylene-based compounds, hexaphenylsiloxane-based compounds, or distyrylanthracene-based compounds. More specifically, the monomer comprises at least one selected from 1,6-hexanediol diacrylate, pentaerythritol tetraacrylate, trimethylolpropane triacrylate, ditrimethylolpropane tetraacrylate, tris(2-hydroxyethyl)isocyanurate triacrylate, or dipentaerythritol pentaacrylate. As an example, the metal ion compound comprises one or more compounds soluble in organic solvents containing Li⁺ ions, Zn²⁺ ions, Yb³⁺ ions, Zr⁴⁺ ions, or Mg²⁺ ions. The photoinitiator can be selected according to practical needs to match the laser wavelength, such as at least one chosen from IRGACURE-250, IRGACURE-907, IRGACURE-184, IRGACURE-369, IRGACURE-819, IRGACURE-1173, IRGACURE-784, IRGACURE-ITX, and IRGACURE-DETC.

### Example 1

A mixture of 97 mol% analytically pure trimethylolpropane triacrylate, 1% IRGACURE-ITX, and 1% tetraphenylethylene was dissolved in acetone. Additionally, a metal ion compound (such as Li⁺, Zn²⁺, Yb³⁺, Zr⁴⁺, or Mg²⁺ compound) was added at 1 mol%. After sonication until fully dissolved, the acetone was removed by heating or vacuum treatment to obtain the prepared optical storage medium material.

The optical storage medium material was mixed with the organic solvent tetrafluoropropanol or acetone in a specific ratio, then dropped onto a substrate rotating at a low speed (300 rpm). Subsequently, the substrate's rotational speed was increased to 1600 rpm to allow the solution to flow outward radially until evenly distributed across the substrate. Finally, the substrate's rotational speed was raised to 5500 rpm to completely evaporate and remove the mixed organic solvent. The uniformly distributed optical storage medium material on the substrate was then exposed to a UV curing lamp to achieve the first pre-curing, resulting in a solid storage medium film.

A dual-beam laser super-resolution writing system was configured to irradiate the solid storage medium film. The first writing laser module 101 emitted a writing beam (pulsed laser with a wavelength of 515 nm), which passed sequentially through the first lens 102, the first pinhole 103, the second lens 104, and the first dichroic mirror 105 before being focused by the objective lens 106 into a solid writing beam (solid spot) onto the optical storage medium material. The second writing laser module 201 emitted an inhibition beam (continuous wave laser with a wavelength of 639 nm), which passed through the third lens 202, the second pinhole 203, the fourth lens 204, and the vortex phase plate 205 to form an annular hollow inhibition beam (annular hollow spot). It then passed sequentially through the second dichroic mirror 206 and the first dichroic mirror 105 into the objective lens 106, where it was focused together with the solid writing beam onto the same position in the optical storage medium material. The three-dimensional distributions of the two writing beams were highly coincident, and a displacement stage 107 controlled the position where the lasers acted on the material, achieving localized second-stage curing, as shown in Fig. 2. Optionally, a fifth lens 108 and a camera 109 were placed on the opposite side of the second dichroic mirror 206 relative to the objective lens 106 to form a real-time imaging system for observing the information writing process.

After information writing was completed, a dual-beam super-resolution laser readout system was configured. The first beam, a pulsed laser S01 with a wavelength of 405 nm, passed through a dichroic mirror S03 and entered the objective lens S04 to be focused onto the storage medium S05. The second beam, a continuous-wave laser S02 with a wavelength of 520 nm, passed through a vortex phase plate S06 to form an annular hollow inhibition beam (annular hollow spot) and then through a dichroic mirror S07 into the objective lens S04, where it was focused onto the storage medium S05. The signal was collected by a lens S08 and directed to a weak-light detector S09 for super-resolution readout of the information recording points, as shown in Fig. 3.

The power densities of the writing beam and the inhibition beam were 2.85 GW/cm² and 0.05 MW/cm², respectively. Using the metal-doped optical storage medium, 35 layers of information were written and read with an inter-layer spacing of 1.5 µm, as shown in Fig. 4. The fluorescence contrast of information recording points without metal-ion doping and with doping of different metal-ion compounds is presented in Table 1.

**Table 1**

| Example 1 (Tetraphenylethylene) | Writing beam power density | inhibition beam power density | fluorescence contrast |
|---|---|---|---|
| No metal ions | 2.85 GW/cm² | 0.05 MW/ cm² | 6: 1 |
| Zn2+ Ions | 2.85 GW/cm² | 0.05 MW/ cm² | 30: 1 |
| Mg2+ Ions | 2.85 GW/cm² | 0.05 MW/ cm² | 12: 1 |
| Zr4+ Ions | 2.85 GW/cm² | 0.05 MW/ cm² | 16: 1 |
| Li+ Ions | 2.85 GW/cm² | 0.05 MW/ cm² | 8: 1 |
| Yb3+ Ions | 2.85 GW/cm² | 0.05 MW/ cm² | 14: 1 |

### Example 2

A mixture of 94 mol% analytically pure dipentaerythritol pentaacrylate, 1.5% IRGACURE-ITX, and 3% hexaphenylsilole was dissolved in acetone. Additionally, a metal ion compound (such as Li⁺, Zn²⁺, Yb³⁺, Zr⁴⁺, or Mg²⁺ compound) was added at 1.5 mol%. After sonication until fully dissolved, the acetone was removed by heating or vacuum treatment to obtain the prepared optical storage medium material. The fluorescence contrast of the information recording points was evaluated, using the optical storage medium material without the added ion compound as a reference for comparison.

The optical storage medium material was mixed with the organic solvent tetrafluoropropanol or acetone in a specific ratio and then dropped onto a substrate rotating at a low speed (300 rpm). Subsequently, the rotational speed of the substrate was increased to 1600 rpm to allow the solution to flow outward radially until it was evenly distributed across the substrate. Finally, the rotational speed was raised to 5500 rpm to completely evaporate and remove the mixed organic solvent. The uniformly distributed optical storage medium material on the substrate was exposed to a UV curing lamp to achieve the first pre-curing, resulting in a solid storage medium film.

A dual-beam laser super-resolution writing system was set up to irradiate the solid storage medium film. The first writing laser module 101 emitted a writing beam (pulsed light with a wavelength of 515 nm), which passed sequentially through the first lens 102, the first pinhole 103, the second lens 104, and the first dichroic mirror 105 before being focused by the objective lens 106 into a solid writing beam (solid spot) onto the optical storage medium material. The second writing laser module 201 emitted an inhibition beam (continuous light with a wavelength of 639 nm), which passed sequentially through the third lens 202, the second pinhole 203, the fourth lens 204, and the vortex phase plate 205 to form an annular hollow inhibition beam (annular hollow spot). It then passed through the second dichroic mirror 206 and the first dichroic mirror 105 before entering the objective lens 106, where it was focused together with the solid writing beam onto the same position within the optical storage medium material. The three-dimensional distributions of the two writing beams were highly coincident, and a displacement stage 107 controlled the position of laser interaction with the material to achieve localized second-stage curing, as shown in Fig. 2. Optionally, a fifth lens 108 and a camera 109 were placed on the side opposite the objective lens 106 relative to the second dichroic mirror 206 to form a real-time imaging system for observing the information writing process.

After the information writing was completed, a dual-beam super-resolution laser readout system was configured. The first beam was a pulsed laser S01 with a wavelength of 480 nm, which passed through a dichroic mirror S03 and entered the objective lens S04 to be focused onto the storage medium S05. The second beam was a continuous light S02 with a wavelength of 592 nm, which passed through a vortex phase plate S06 to form an annular hollow inhibition beam (annular hollow spot) and then through a dichroic mirror S07 into the objective lens S04, where it was focused onto the storage medium S05. The signal was collected by a lens S08 and directed to a weak-light detector S09 for super-resolution readout of the information recording points, as shown in Fig. 3. The power densities of the writing beam and the inhibition beam were 2.85 GW/cm² and 0.05 MW/cm², respectively. The fluorescence contrast of the information recording points is shown in Table 2.

**Table 2**

| Example 2 (Hexaphenylsilole) | Writing beam power density | inhibition beam power density | fluorescence contrast |
|---|---|---|---|
| No metal ions | 2.85 GW/cm2 | 0.05 MW/ cm2 | 14: 1 |
| Zn2+Ions | 2.85 GW/cm2 | 0.05 MW/ cm2 | 28: 1 |
| Mg2+ Ions | 2.85 GW/cm2 | 0.05 MW/ cm2 | 20: 1 |
| Zr4+ Ions | 2.85 GW/cm2 | 0.05 MW/ cm2 | 60: 1 |
| Li+ Ions | 2.85 GW/cm2 | 0.05 MW/ cm2 | 16: 1 |
| Yb3+ Ions | 2.85 GW/cm² | 0.05 MW/ cm² | 27: 1 |

### Example 3

A mixture consisting of 93 mol% analytically pure dipentaerythritol pentaacrylate, 3% IRGACURE-ITX, 2% Zr⁴⁺ ion compound, and 2% hexaphenylsilole was dissolved in acetone. After sonication until complete dissolution, the acetone was removed by heating or vacuum treatment to obtain the prepared optical storage medium material.

The optical storage medium material was mixed with the organic solvent tetrafluoropropanol or acetone in a specific ratio and then dropped onto a substrate rotating at a low speed (400 rpm). Subsequently, the rotational speed of the substrate was increased to 1700 rpm to allow the solution to flow outward radially until evenly distributed across the substrate. Finally, the rotational speed was raised to 4800 rpm to completely evaporate and remove the mixed organic solvent. The uniformly distributed optical storage medium material on the substrate was exposed to a UV curing lamp to achieve the first pre-curing, resulting in a solid storage medium film.

A dual-beam laser super-resolution writing system was configured to irradiate the solid storage medium film. The first writing laser module 101 emitted a writing beam (pulsed laser with a wavelength of 515 nm), which passed sequentially through the first lens 102, the first pinhole 103, the second lens 104, and the first dichroic mirror 105 before being focused by the objective lens 106 into a solid writing beam (solid spot) onto the optical storage medium material. The second writing laser module 201 emitted an inhibition beam (continuous light with a wavelength of 639 nm), which passed sequentially through the third lens 202, the second pinhole 203, the fourth lens 204, and the vortex phase plate 205 to form an annular hollow inhibition beam (annular hollow spot). It then passed through the second dichroic mirror 206 and the first dichroic mirror 105 before entering the objective lens 106, where it was focused together with the solid writing beam onto the same position within the optical storage medium material. The three-dimensional distributions of the two writing beams were highly coincident, and a displacement stage 107 controlled the position of laser interaction with the material to achieve localized second-stage curing, as shown in Fig. 2. Optionally, a fifth lens 108 and a camera 109 were placed on the side opposite the objective lens 106 relative to the second dichroic mirror 206 to form a real-time imaging system for observing the information writing process.

After information writing was completed, a dual-beam super-resolution readout system was set up. The first beam was a pulsed laser S01 with a wavelength of 480 nm, which passed through a dichroic mirror S03 and entered the objective lens S04 to be focused onto the storage medium S05. The second beam was a continuous light S02 with a wavelength of 592 nm, which passed through a vortex phase plate S06 to form an annular hollow inhibition beam (annular hollow spot) and then through a dichroic mirror S07 into the objective lens S04, where it was focused onto the storage medium S05. The signal was collected by a lens S08 and directed to a weak-light detector S09 for super-resolution readout of the information recording points, as shown in Fig. 3.

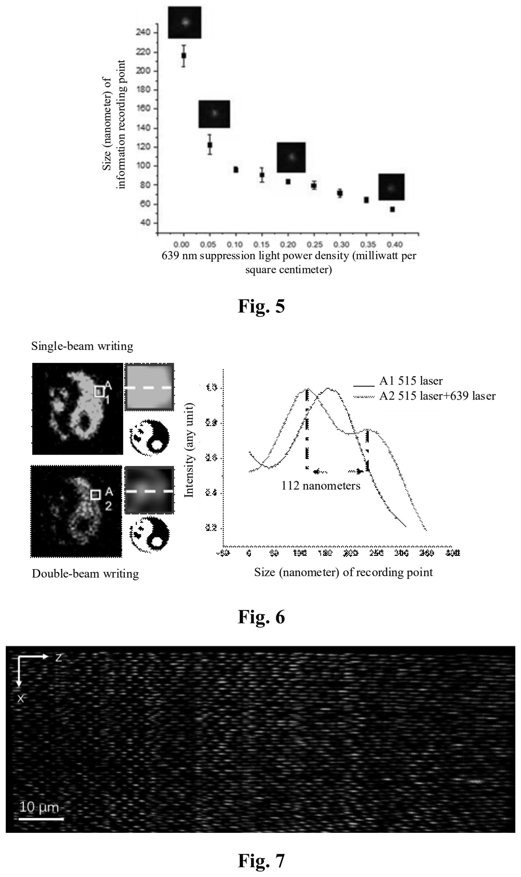

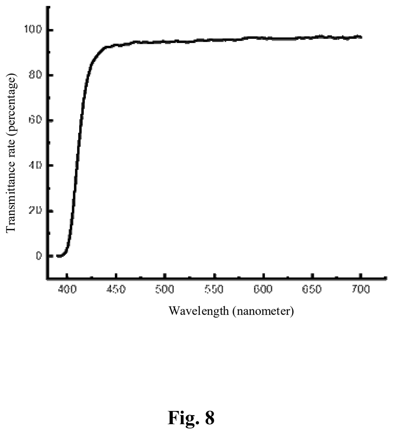

As shown in Fig. 5, with the writing beam power density fixed at 2.14 GW/cm², the size of the recording points gradually decreased as the power density of the inhibition beam was increased. When the inhibition beam power density reached 0.4 MW/cm², the minimum single-point size achieved was 54 nm. Under identical writing power density conditions, a comparison was made between the super-resolution readout performance for dual-beam writing with a track pitch of 112 nm under single-beam and dual-beam writing scenarios, as shown in Fig. 6. It can be observed that at a track pitch of 112 nm, the two super-resolution recording points could only be distinguished through dual-beam super-resolution writing. Furthermore, a multi-layer recording experiment with 100 layers and an inter-layer spacing of 1 µm was conducted, and its cross-sectional results are shown in Fig. 7. Moreover, the optical storage medium material exhibited high transmittance, with transmittance greater than 80% across the wavelength range of 430 nm to 700 nm, as shown in Fig. 8.

### Example 4

A mixture consisting of 99.7 mol% analytically pure pentaerythritol tetraacrylate, 0.1% IRGACURE-ITX, 0.1% Mg²⁺ ion compound, and 0.1% hexaphenylsilole was dissolved in acetone. After ultrasonication until fully dissolved, the acetone was removed by heating or vacuum treatment to obtain the prepared optical storage medium material.

The optical storage medium material was mixed with the organic solvent tetrafluoropropanol or acetone in a certain ratio and then dropped onto a substrate rotating at a low speed (400 rpm). Subsequently, the rotation speed of the substrate was increased to 1700 rpm to allow the solution to flow outward along the radial direction until it was uniformly distributed on the substrate. Finally, the rotation speed of the substrate was increased to 4800 rpm to completely volatilize and remove the mixed organic solvent. The optical storage medium material evenly distributed on the substrate was exposed and subjected to the first pre-curing using a UV curing lamp, resulting in a solid storage medium film.

A dual-beam laser super-resolution writing system was set up to irradiate the solid storage medium film. The first writing laser module 101 emitted a writing beam (pulsed laser with a wavelength of 515 nm), which sequentially passed through the first lens 102, the first pinhole 103, the second lens 104, and the first dichroic mirror 105 before entering the objective lens 106, where it was focused into a solid writing beam (solid spot) onto the optical storage medium material. The second writing laser module 201 emitted an inhibition beam (continuous light with a wavelength of 639 nm), which sequentially passed through the third lens 202, the second pinhole 203, the fourth lens 204, and the vortex phase plate 205 to form an annular hollow inhibition beam (annular hollow spot). It then sequentially passed through the second dichroic mirror 206 and the first dichroic mirror 105 before entering the objective lens 106, where it was focused together with the solid writing beam onto the same position in the optical storage medium material. The three-dimensional distributions of the two writing beams were highly coincident, and the laser interaction position on the material was controlled via the displacement stage 107 to achieve localized second curing, as shown in Figure 2. Optionally, a fifth lens 108 and a camera 109 were sequentially placed on the opposite side of the second dichroic mirror 206 relative to the objective lens 106 to form a real-time imaging system for observing the information writing process.

After the information writing was completed, a dual-beam super-resolution readout system was configured. In this system, the first beam was a pulsed laser S01 with a wavelength of 480 nm, which passed through a dichroic mirror S03 and entered the objective lens S04 to be focused onto the storage medium S05. The second beam was a continuous light S02 with a wavelength of 592 nm, which passed through a vortex phase plate S06 to form an annular hollow inhibition beam (annular hollow spot) and then passed through a dichroic mirror S07 to enter the objective lens S04, where it was focused onto the storage medium S05. The signal was collected by a lens S08 and directed to a weak-light detector S09 for super-resolution readout of the information recording points. With writing beam power density and inhibition power density of 2.90 GW/cm² and 0.1 MW/cm², respectively, recording with a track pitch of 165 nm and multi-layer recording of 45 layers with an inter-layer spacing of 1.2 µm were achieved.

### Example 5

A mixture consisting of 85 mol% analytically pure pentaerythritol tetraacrylate, 5% IRGACURE-DETC, 5% Mg²⁺ ion compound, and 5% distyrylanthracene-based compound was dissolved in acetone. After sonication until fully dissolved, the acetone was removed by heating or vacuum treatment to obtain the prepared optical storage medium material.

The optical storage medium material was mixed with the organic solvent tetrafluoropropanol or acetone in a specific ratio and then dropped onto a substrate rotating at a low speed (400 rpm). Subsequently, the rotational speed of the substrate was increased to 1700 rpm to allow the solution to flow outward radially until it was evenly distributed across the substrate. Finally, the rotational speed was raised to 4800 rpm to completely evaporate and remove the mixed organic solvent. The uniformly distributed optical storage medium material on the substrate was exposed to a UV curing lamp to achieve the first pre-curing, resulting in a solid storage medium film.

A dual-beam laser super-resolution writing system was set up to irradiate the solid storage medium film. The first writing laser module 101 emitted a writing beam (pulsed laser with a wavelength of 800 nm), which passed sequentially through the first lens 102, the first pinhole 103, the second lens 104, and the first dichroic mirror 105 before being focused by the objective lens 106 into a solid writing beam (solid spot) onto the optical storage medium material. The second writing laser module 201 emitted an inhibition beam (continuous light with a wavelength of 532 nm), which passed sequentially through the third lens 202, the second pinhole 203, the fourth lens 204, and the vortex phase plate 205 to form an annular hollow inhibition beam (annular hollow spot). It then passed through the second dichroic mirror 206 and the first dichroic mirror 105 before entering the objective lens 106, where it was focused together with the solid writing beam onto the same position within the optical storage medium material. The three-dimensional distributions of the two writing beams were highly coincident, and a displacement stage 107 controlled the position of laser interaction with the material to achieve localized second-stage curing, as shown in Fig. 2. Optionally, a fifth lens 108 and a camera 109 were placed on the side opposite the objective lens 106 relative to the second dichroic mirror 206 to form a real-time imaging system for observing the information writing process.

After the information writing was completed, a dual-beam super-resolution readout system was configured. The first beam was a pulsed laser S01 with a wavelength of 410 nm, which passed through a dichroic mirror S03 and entered the objective lens S04 to be focused onto the storage medium S05. The second beam was a continuous light S02 with a wavelength of 480 nm, which passed through a vortex phase plate S06 to form an annular hollow inhibition beam (annular hollow spot) and then through a dichroic mirror S07 into the objective lens S04, where it was focused onto the storage medium S05. The signal was collected by a lens S08 and directed to a weak-light detector S09 for super-resolution readout of the information recording points. With writing beam and inhibition beam power densities of 2.85 GW/cm² and 0.33 MW/cm², respectively, recording with a track pitch of 155 nm and multi-layer recording of 45 layers with an inter-layer spacing of 1.3 µm were achieved.

The embodiments described above merely represent specific modes of implementation of the present invention, which are described in detail and with particularity, but should not be construed as limiting the scope of the invention. It should be noted that those of ordinary skill in the art may make various modifications and variations without departing from the inventive concept of the present invention, and such modifications and variations shall fall within the protection scope of the invention. Therefore, the protection scope of the present invention shall be defined by the appended claims.

## Claims

1. An optical storage medium, comprising components: a photoinitiator, a monomer, a metal ion compound, and an aggregation-induced emission dye, wherein molar amounts of all the components in a material are shown as follows: the photoinitiator accounts for 0.1% to 5%, the aggregation-induced emission dye accounts for 0.1% to 5%, the metal ion compound accounts for 0.1% to 5%, and the monomer accounts for 85% to 99.7%.

2. A super-resolution information write-in method based on the optical storage medium of claim 1, comprising:
irradiating the optical storage medium by using a solid beam with a wavelength λ₁, such that an aggregation-induced emission effect is generated in an irradiation area to enhance a fluorescence intensity;
irradiating a surrounding area of the solid beam irradiation area by using a hollow beam with a wavelength λ₂, such that an aggregation-induced emission suppression effect is generated in the surrounding area to suppress the fluorescence intensity; and
recording information by using a fluorescence contrast between the irradiation area and the surrounding area to form an information recording point with a size smaller than a diffraction limit.

3. The super-resolution information write-in method of claim 2, wherein central positions of the solid beam and the hollow beam coincide in three-dimensional space.

4. The super-resolution information write-in method of any one of claims 2 to 3, wherein a fluorescence contrast between the information recording point and an information unrecording area is greater than 10:1.

5. The super-resolution information write-in method of any one of claims 2 to 3, wherein the size of the information recording point is smaller than the diffraction limit λ₁/2NA, wherein NA is a numerical aperture of an objective lens.

6. The optical storage medium of claim 1, wherein the metal ion compound comprises one or more organic-solvent-soluble compounds containing Li⁺, Zn²⁺, Yb³⁺, Zr⁴⁺, or Mg²⁺.

7. The optical storage medium of claim 6, wherein the aggregation-induced emission dye comprises one or more of tetraphenylethene, hexaphenylsiloxane, and stilbeneanthracene; the monomer comprises one or more of 1,6-hexanediol diacrylate, pentaerythritol tetraacrylate, trimethylolpropane triacrylate, di(trimethylolpropane) tetraacrylate, tri(2-hydroxyethyl) isocyanurate triacrylate, and dipentaerythritol pentaacrylate; and the photoinitiator comprises one or more mixtures of IRGACURE-250, IRGACURE-907, IRGACURE-184, IRGACURE-369, IRGACURE-819, IRGACURE-1173, IRGACURE-784, IRGACURE-ITX, and IRGACURE-DETC.

8. The optical storage medium of claim 1, wherein the optical storage medium is attached to a substrate and is UV pre-cured.

9. The optical storage medium of claim 8, wherein the optical storage medium is prepared by adopting the following method:
(1) placing the photoinitiator with the molar ratio of 0.1% to 5%, the aggregation-induced emission dye with the molar ratio of 0.1% to 5%, the metal ion compound with the molar ratio of 0.1% to 5% and the monomer with the molar ratio of 85% to 99.7% in an acetone solution, performing ultrasonic mixing, and then, removing all the acetone solutions by oven baking to obtain an optical storage medium material;
(2) mixing the optical storage medium material in step (1) with an organic solvent such as tetrafluoropropanol or acetone in a certain proportion, and dropping the solution on the substrate rotating at a low speed (a rotating speed is 200 rpm to 600 rpm); then, increasing the rotating speed of the substrate to 800 rpm to 2000 rpm to make the solution radially flow outwards on the substrate until the solution is uniformly distributed on the substrate; and finally, increasing the rotating speed of the substrate to 4800 rpm to 6500 rpm to completely evaporate and remove the mixed organic solvent; and
(3) exposing the optical storage medium material uniformly distributed on the substrate and achieving first pre-curing by adopting a UV curing lamp to obtain a solid storage medium film.

10. A super-resolution information readout method based on an optical storage medium, wherein the method comprises the following steps:
irradiating the optical storage medium by using a solid beam with a wavelength λ₃ and a hollow beam with a wavelength λ₄, wherein the optical storage medium is doped with an aggregation-induced emission dye; performing spontaneous radiation from ground-state electrons to excited-state electrons by using the solid beam with the wavelength λ₃ and stimulated radiation on the excited-state electrons by using the hollow beam with the wavelength λ₄; and collecting an aggregation-induced fluorescence enhancement signal to read out an information recording point;
wherein the wavelength λ₄ is greater than the wavelength λ₃.

11. A super-resolution information write-in device based on an optical storage medium, comprising an optical path module and a control module;
wherein the optical path module is configured to form a solid beam with a wavelength λ₁ and a hollow beam with a wavelength λ₂ and irradiate the optical storage medium by using the solid beam with the wavelength λ₁, such that an aggregation-induced emission effect is generated in an irradiation area to enhance a fluorescence intensity, wherein the optical storage medium is doped with an aggregation-induced emission dye; irradiate a surrounding area of the solid beam irradiation area by using the hollow beam with the wavelength λ₂, such that an aggregation-induced emission suppression effect is generated in the surrounding area to suppress the fluorescence intensity; and record information by using a fluorescence contrast between the irradiation area and the surrounding area to form an information recording point with a size smaller than a diffraction limit; and
the control module is configured to control the z-direction displacement of an objective lens or the optical storage medium and regulate focal positions of the solid beam and the hollow beam in the optical storage medium.

12. The information write-in device of claim 11, wherein the optical path module comprises a first write-in laser module, a first lens, a first aperture, a second lens, a first dichroic mirror, a second write-in laser module, a third lens, a second aperture, a fourth lens, a vortex phase plate, a second dichroic mirror, and the objective lens;
wherein the first write-in laser module emits a beam of continuous light with a wavelength ranging from 200 nm to 400 nm or a pulsed laser with a wavelength ranging from 400 nm to 800 nm, which enters the objective lens through the first lens, the first aperture, the second lens and the first dichroic mirror and is focused to form the solid beam with the wavelength λ₁ to be stored into the optical storage medium; and
the second write-in laser module emits a beam of continuous light or pulsed laser with a wavelength ranging from 500 nm to 800 nm, which forms the hollow beam with the wavelength λ₂ through the third lens, the second aperture, the fourth lens and the vortex phase plate, and then, the hollow beam enters the objective lens through the second dichroic mirror and the first dichroic mirror and is focused together with the solid beam with the wavelength λ₁ to the same position on the optical storage medium, wherein central positions of the solid beam and the hollow beam coincide in three-dimensional space.

13. A super-resolution information readout device based on an optical storage medium, comprising a readout optical path module configured to form double beams that are a solid beam with a wavelength λ₃ and a hollow beam with a wavelength λ₄, wherein the optical storage medium is doped with an aggregation-induced emission dye, and the double beams are used for irradiating the optical storage medium; perform spontaneous radiation from ground-state electrons to excited-state electrons by using the solid beam with the wavelength λ₃ and stimulated radiation on the excited-state electrons by using the hollow beam with the wavelength λ₄; and collect an aggregation-induced fluorescence enhancement signal to read out an information recording point; wherein the wavelength λ₄ is greater than the wavelength λ₃.
